# EUROPÄISCHE PATENTSCHRIFT

(11) **EP 0 679 054 B1**
(45) Veröffentlichungstag und Bekanntmachung des Hinweises auf die Patenterteilung: **24.06.1998**
(21) Anmeldenummer: 95105002.0
(22) Anmeldetag: 04.04.1995
(51) Int. Cl.: H05K 13/08

(54) **Verfahren zur Codierung von Leiterplatten**
Coding device for printed circuit boards
Dispositif pour codage de circuits imprimés

(30) Priorität: 21.04.1994 DE 4413910
(43) Veröffentlichungstag der Anmeldung: 25.10.1995
(73) Patentinhaber: TEMIC TELEFUNKEN microelectronic GmbH, 74072 Heilbronn (DE)
(72) Erfinder: Schaller, Günter, D-92363 Breitenbrunn/Opf. (DE)
(74) Vertreter: Maute, Hans-Jürgen, Dipl.-Ing.

(56) Entgegenhaltungen:
- PATENT ABSTRACTS OF JAPAN vol. 16 no. 156 (E-1191) ,17.April 1992 & JP-A-04 010488 (TOSHIBA) 10.Januar 1992,
- PATENT ABSTRACTS OF JAPAN vol. 10 no. 160 (P-465) [2216] ,7.Juni 1986 & JP-A-61 014549 (FUJITSU) 22.Januar 1986,

## Beschreibung

Die Erfindung betrifft ein Verfahren zur Codierung von Leiterplatten zur automatischen Erkennung von wenigstens zwei Bestückungsvarianten der Leiterplatten für einen aus mehreren Bestückungsvorgängen bestehenden Fertigungsdurchlauf zur Bestückung der Leiterplatten mit elektronischen und nichtelektronischen Bauelementen.

In der industriellen Fertigung von Elektronikbaugruppen werden häufig unterschiedliche Varianten mit Sonder- oder Zusatzfunktionen hergestellt. Die zugehörigen Leiterplatten unterscheiden sich dabei durch eine unterschiedliche Bestückung, so daß eine gewisse Anzahl von Bestückungsvarianten vorliegt. Zur Kosteneinsparung im Fertigungsprozeß versucht man die Variantenvielfalt mit nur einer Basis-Leiterplatte abzudecken. Dabei besteht das Problem, daß nun der Bestückungsautomat bei jedem Produktionsschritt die unterschiedlichen Bestückungsvarianten selbst erkennen muß. Dabei besteht die Gefahr, daß während des Produktionsdurchlaufes Verwechslungen entstehen.

Es ist bekannt, zur Kennzeichnung von Platten zur eindeutigen Unterscheidung von verschiedenen Bestückungsvarianten Klebeetiketten oder Barcodes aufzubringen, was jedoch zusätzlichen Arbeits- und Materialaufwand bedingt und daher zu zusätzlichen Produktionskosten führt. Bei doppelseitig bestückten Leiterplatten besteht dann zusätzlich das Problem, da solche Klebeetiketten oder Barcodes nur von einer Seite lesbar sind.

Patent Abstracts of Japan, Vol. 16, no. 156 (E-1191), 17. April 1992, offenbart ein Verfahren zur Codierung von Leiterplatten, wobei eine Drahtbrucke an verschiedenen Positionen einer Anordnung von Bohrlochpaaren einsetzbar ist.

Der Erfindung liegt daher die Aufgabe zugrunde, eine maschinenlesbare Codierung von Leiterplatten anzugeben, die einfach auf der Leiterplatte anzubringen ist und eine hohe Sicherheit bezüglich der Erkennung durch die Maschine aufweist.

Diese Aufgabe wird durch die kennzeichnenden Merkmale des Patentanspruches 1 gelöst. Hiernach wird das Verfahren mit Leiterplatten durchgeführt, die jeweils Anschlußnester für wenigstens ein Codierbauelement aufweisen, wobei im Bereich zwischen diesen Anschlußnestern eine durch das Codierbauelement abdeckbare Codieröffnung vorgesehen ist. Somit können zwei Bestückungsvarianten codiert werden, je nachdem ob im ersten Bestückungsvorgang die Leiterplatte mit oder ohne Codierbauelement teilbestückt wird. Dieses Codierbauelement stellt in der Regel ein Standardbauteil dar, das von der Bestückungsmaschine zusätzlich zu den anderen Bauelementen an dem speziellen Anschlußnest mitbestückt wird. Da zwischen den das Anschlußnest bildenden Anschlußflecken des Codierbauelementes die Codieröffnung angebracht ist, kann diese mittels einer Lichtschranke detektiert werden. Damit ist diese Codierung auch von der Unterseite erkennbar. Vor jedem Bestückvorgang kann nun der Bestückungsautomat die Position der Codieröffnung überprüfen und je nachdem ob diese Codieröffnung verdeckt oder offen ist, die entsprechende Bestückungsvariante erkennen.

Müssen mehr als zwei Bestückungsvarianten durch die Bestückungsmaschine erkannt werden, ist eine entsprechende Anzahl von Codieröffnungen auf der Leiterplatte vorzusehen.

Die vorgeschlagene erfindungsgemäße Kennzeichnung ist äußerst kostengünstig und platzsparend, da kein zusätzlicher Arbeitsschritt durch Aufbringen einer Codierung, beispielsweise von Etiketten oder Barcodes, notwendig ist. Die Bestückung mit dem Codierbauelement fällt dagegen kaum ins Gewicht. Auch brauchen an der Bestückungsmaschine keine technischen Änderungen vorgenommen werden, da in der Regel an jeder Bestückungsmaschine eine Positionskamera vorhanden ist.

Weiterhin besteht keine Gefahr von Vermischungen von zu verschiedenen Bestückungsvarianten gehörenden Leiterplatten, da die Bestückungsmaschine jede einzelne Leiterplatte kontrolliert und die Codierung für den gesamten Produktionsdurchlauf, also bis zum Endmessplatz erkennbar bleibt.

Schließlich ist es auch ein Vorteil, daß das Bedienpersonal der Bestückungsmaschine während jedes Prozeßschrittes die Codierung ebenfalls eindeutig erkennen kann.

Das erfindungsgemäße Verfahren kann mit Vorteil zur Bestückung von Leiterplatten mit SMD (Surface Mounted Device)-Bauelementen verwendet werden. Da die erfindungsgemäße Codierung von beiden Seiten der Leiterplatte erkennbar ist, läßt sich das Verfahren auch für doppelseitig zu bestückende Leiterplatten einsetzen.

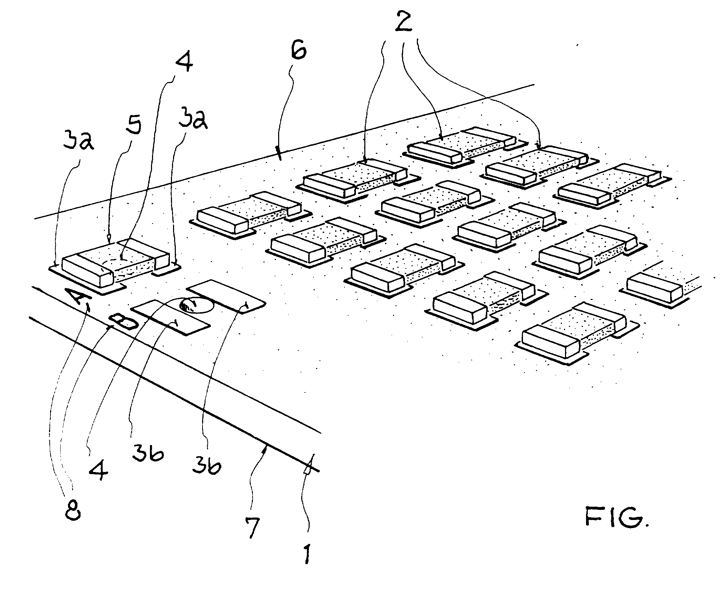

Im folgenden soll das erfindungsgemäße Verfahren anhand einer mit SMD-Bauelementen bestückten Leiterplatte gemäß der Figur erläutert werden. Diese Figur zeigt eine mit SMD-Bauelementen 2 teilbestückte Leiterplatte 1 nach einem ersten Bestückungsvorgang eines aus mehreren Bestückungsvorgängen bestehenden Fertigungsdurchlaufes. Eine die Reflow-Seite 6 tragende Codierung besteht aus zwei Anschlußnestern 3a und 3b mit jeweils zwei Anschlußflecken, wobei das erstgenannte Anschlußnest 3a mit einem als Standard-SMD-Bauelement ausgebildetes Codierbauelement 5 bestückt ist. Zwischen den beiden Anschlußflecken jedes Anschlußnestes 3a und 3b ist jeweils eine Codieröffnung 4 durch die Leiterplatte 1 angebracht. Die Codieröffnung 4 des Anschlußnestes 3a wird durch das Codierbauelement 5 verdeckt, während die Codieröffnung 4 des Anschlußnestes 3b offen bleibt. Gleichzeitig mit dem ersten Bestückungsvorgang wird die Leiterplatte 1 nicht nur mit diesem Codierbauelement 5, sondern auch mit den für die Reflow-Seite 6 vorgesehenen SMD-Bauelementen 2 bestückt.

Vor dem nächsten Bestückungsvorgang, also der Bestückung der Schwall-Seite 7, prüft der Bestückungsautomat mittels einer Positionskamera, ob die Codieröffnungen 4 verdeckt oder offen sind und kann somit eindeutig eine von vier möglichen Bestückungsvarianten dieser Leiterplatte 1 zuordnen. Die in der Figur dargestellte Leiterplatte kann als Basis-Leiterplatte bezeichnet werden, da in dem darauffolgenden Bestückungsvorgang die Leiterplatte mit den nun variantenspezifischen Bauelementen bestückt wird.

Auch nach Beendigung der Bestückung der Schwall-Seite 7 kann die Kennzeichnung noch für weitere kritische Fertigungsschritte mit Verwechslungsgefahr, wie zum Beispiel das Aufnieten einer Steckerleiste, benutzt werden. Die Figur zeigt noch eine Beschriftung 8 mit den Großbuchstaben A und B als Bestückungsdruck zur Beschriftung der Bestückungsvariante, um dem Bedienungspersonal des Bestückungsautomaten eine leichtere Identifizierung der Leiterplatte zu ermöglichen.

Das erfindungsgemäße Codierungsverfahren ist einmal sehr platzsparend, da Klebeketten oder Barcodes mehr Fläche der Leiterplatte beanspruchen würden als das erfindungsgemäße Codierbauelement und andererseits äußerst kostengünstig, da zusätzliche Arbeitsschritte zum Aufbringen der Codierung, beispielsweise durch Etiketten oder Barcodes entfallen und an der Bestückungsmaschine keine technischen Änderungen vorgenommen werden müssen, da in der Regel eine Positionskamera vorhanden ist. Ferner braucht nur ein Unterlagensatz für nur eine Leiterplatte erstellt und verwaltet werden.

Schließlich wird mit dem erfindungsgemäßen Verfahren auch eine hohe Erkennungssicherheit erzielt, da sich ein Codierbauelement nicht ablösen kann bzw. der Fall einer Unleserlichkeit nicht auftreten kann.

Die Verwendung des erfindungsgemäßen Verfahrens ist natürlich nicht nur auf die Bestückung mit SMD-Bauelementen gemäß dem beschriebenen Ausführungsbeispiel anwendbar, sondern kann bei der Bestückung von Leiterplatten mit jeglicher Art von Bauelementen eingesetzt werden.

## Patentansprüche

1. Verfahren zur Codierung von Leiterplatten (1) zur automatischen Erkennung von wenigstens zwei Bestückungsvarianten der Leiterplatten (1) für einen aus mehreren Bestückungsvorgängen bestehenden Fertigungsdurchlauf zur Bestückung der Leiterplatten (1) mit elektronischen Bauelementen (2), dadurch gekennzeichnet, daß das Verfahren mit Leiterplatten (1) durchgeführt wird, die jeweils Anschlußnester (3a, 3b) für wenigstens ein weiteres, zur Codierung dienendes elektronisches Bauelement (5) aufweisen, daß im Bereich zwischen diesen Anschlußnestern (3a, 3b) jeweils eine durch das weitere elektronische Bauelement (5) abdeckbare Codieröffnung (4) vorgesehen ist und daß für eine erste Bestückungsvariante die Leiterplatte (1) in einem ersten Bestückungsvorgang ohne weiteres elektronisches Bauelement (5) teilbestückt wird und daß für eine zweite Bestückungsvariante die Leiterplatte (1) im ersten Bestückungsvorgang mit dem weiteren elektronischen Bauelement (5) teilbestückt wird.

2. Verfahren nach Anspruch 1, dadurch gekennzeichnet, daß als elektronische Bauelemente SMD (Surface Mounted Device)-Bauelemente (2) vorgesehen sind.

3. Verfahren nach Anspruch 1 oder 2, dadurch gekennzeichnet, daß doppelseitig bestückbare Leiterplatten (1) vorgesehen sind.

## Claims

1. Method of coding printed circuit boards (1) for automatically identifying at least two variants in respect of the mounting of components on the printed circuit boards (1), for a fabrication run consisting of a plurality of mounting operations for populating the printed circuit boards (1) with electronic components (2), characterised in that, the method is carried out with printed circuit boards (1) each having terminal clusters (3a, 3b) for at least one further electronic component (5) which serves for coding purposes, that a respective coding-opening (4) is provided in the region between these terminal clusters (3a, 3b) and said opening is maskable by the further electronic component (5) and that for the case of a first mounting variant, the printed circuit board (1) is partially populated without a further electronic component (5) in the course of a first mounting operation and, for the case of a second mounting variant, the printed circuit board (1) is partially populated with the further electronic component (5) in the course of the first mounting operation.

2. Method in accordance with Claim 1, characterised in that, SMD components (Surface Mounted Devices) (2) are provided as the electronic components.

3. Method in accordance with Claim 1 or 2, characterised in that, printed circuit boards (1) which can be populated on both sides are provided.

## Revendications

1. Procédé de codage de circuits imprimés (1) en vue de la reconnaissance automatique d'au moins deux variantes d'équipement des circuits imprimés (1) pour un déroulement de fabrication se composant de plusieurs processus d'équipement en vue de la garniture des circuits imprimés (1) avec des composants électroniques (2), caractérisé en ce que le procédé est mis en oeuvre avec des circuits imprimés (1), qui présentent respectivement des cavités de connexion (3a, 3b) pour au moins un autre composant électronique (5) servant au codage, en ce que dans la zone entre ces cavités de connexion (3a, 3b) est prévue respectivement une ouverture de codage (4) pouvant être recouverte par l'autre composant électronique (5) et en ce que pour une variante d'équipement, le circuit imprimé (1) est partiellement équipé au cours d'un premier processus d'équipement simplement du composant électronique (5) et en ce que pour une seconde variante d'équipement, le circuit imprimé (1) est partiellement équipé au cours du premier processus d'équipement avec l'autre composant électronique (5).

2. Procédé selon la revendication 1, caractérisé en ce qu'en tant que composants électroniques sont prévus des composants (2) CMS (Composant Monté en Surface).

3. Procédé selon la revendication 1 ou 2, caractérisé en ce que des circuits imprimés (1) pouvant être garnis des deux côtés sont prévus.
